Europäisches Patentamt

European Patent Office

Office européen des brevets

(11) Veröffentlichungsnummer: **0 326 672**

**A1**

(12) **EUROPÄISCHE PATENTANMELDUNG**

(21) Anmeldenummer: 88119945.9

(22) Anmeldetag: 30.11.88

(51) Int. Cl.⁴: **H03H 17/02**

(30) Priorität: 05.02.88 DE 3803446

(43) Veröffentlichungstag der Anmeldung:
**09.08.89 Patentblatt 89/32**

(84) Benannte Vertragsstaaten:
**AT CH GB LI**

(71) Anmelder: **ANT Nachrichtentechnik GmbH**
**Gerberstrasse 33**
**D-7150 Backnang(DE)**

(72) Erfinder: **Göckler, Heinz, Dipl.-Ing.**
**Elbinger Strasse 52**
**D-7150 Backnang(DE)**

(54) Verfahren und Übertragungsanordung für digitale Signale.

㊼ Verfahren zur digitalen Übertragung, das mit codierten Abtastproben arbeitet und wobei die Übertragungsfunktion ohne Betriebsunterbrechung ausgehend von einer Anfangsübertragungsfunktion störungsarm bis zu einer Endübertragungsfunktion ·verändert werden kann, wobei mittels Umschaltmitteln für die jeweils einem Übertragungsglied zuzuordnenden Übertragungskoeffizienten eine Umschaltung von einem Anfangskoeffizientensatz auf einen Endkoeffizientensatz bewirkt und ist dadurch gekennzeichnet, daß die Umschaltung vom Anfangskoeffizientensatz c0 auf den Endkoeffizientensatz cN in mehreren Schritten so erfolgt, daß ein vorgegebener Systemparameter, ausgehend von einem Anfangswert q0 über Zwischenwerte qn zu einem gewünschten Endwert qN, z. B. in äquidistanten Inkrementen linear interpoliert wird mit

$q_n = q_0 + n \cdot (q_N - q_0)/N = q_0 + n \cdot \Delta q/N,$

daß jeweils für diese Zwischenwerte qn die entsprechenden Zwischenkoeffizientensätze cn ermittelt werden und daß ausgehend von dem Anfangskoeffizientensatz c0 schrittweise jeweils auf die den nächstfolgenden Inkrementen entsprechenden Zwischenkoeffizientensätze cn umgeschaltet wird, bis der Endkoeffizientensatz cN erreicht ist.

Fig. 5

**EP 0 326 672 A1**

## Verfahren und Übertragungsanordnung für digitale Signale

Die Erfindung betrifft ein Verfahren zur digitalen Übertragung bzw. eine Übertragungsanordnung für digitale Signale nach dem Oberbegriff der Patentansprüche 1, 3 bzw. 4 und 6.

Solche Verfahren bzw. Übertragungsanordnungen sind im allgemeinen bei digitaler Filterung, aber auch bei Pegeleinstellung, anwendbar, wobei Filterparameter (also ein Koeffizientensatz eines Übertragungsgliedes) während des Betriebes umgeschaltet werden. Als digitale Signale kommen Sprach-, Musik-, aber auch nicht hörbare Signale in Betracht.

Die einfachste Methode, die Übertragungsfunktion einer Übertragungsanordnung für digitale Signale während des Betriebs zu ändern, besteht darin, zwischen 2 Abtastzeitpunkten den gesamten Koeffizientensatz auszutauschen. Eine solche abrupte momentane Umschaltung des Koeffizientensatzes führt jedoch ohne spezielle Maßnahmen für eine Störunterdrückung zu Störungen im Ausgangssignal der Übertragungsanordnung, und zwar - beispielsweise bei Audiosignalen - zu Störungen, die für das Gehör unangenehm sind. Es entstehen beispielsweise Knackgeräusche, die je nach vorliegender Konfiguration und zufälliger Wahl des Umschaltzeitpunktes mehr oder weniger unangenehm in Erscheinung treten.

Es ist denkbar, solche Störungen durch Einschalten von Störunterdrückungsgliedern in den Weg für die digitalen Signale zu reduzieren. Solche Lösungen haben sich aber als nicht voll befriedigend erwiesen, da sie auch das Nutzsignal in unerwünschter Weise beeinflussen. Dagegen ist in der früheren Patentanmeldung P 33 33 274.6 vorgeschlagen worden, parallel zum Übertragungsglied, dessen Koeffizientensatz umschaltbar sein sollte, einen zweiten Zweig mit einem zweiten digitalen Übertragungsglied vorzusehen. Wird eine Veränderung der Übertragungsfunktion des ersten Übertragungsgliedes gewünscht, so werden statt einer Änderung der Koeffizienten des ersten Übertragungsgliedes die Koeffizienten des zweiten Übertragungsgliedes auf die gewünschten Werte umgeschaltet. Die Ausgangsgröße des zweiten Übertragungsgliedes wird aber über Umschaltmittel erst dann an den Ausgang der Übertragungsanordnung weitergeleitet, wenn ein Diskriminator, der um die Einschwingzeit des zweiten Übertragungsgliedes verzögert wirksam geschaltet wird, nach einem Vergleich der Ausgangsgrößen der beiden Übertragungsglieder die Umschaltung der Umschaltmittel bewirkt.

Diese Übertragungsanordnung hat jedoch eine Reihe von Nachteilen, deren schwerwiegendster ist, daß der Hardware- oder Rechenaufwand verdoppelt werden muß, um die Koeffizientenumschaltung zu ermöglichen.

In der weiteren Patentanmeldung P 33 33 275.4 ist vorgeschlagen worden, daß den Übertragungsgliedern über Umschaltmittel Zwischenkoeffizienten (gebildet durch Interpolationswerte zwischen einem Anfangs- und einem Endkoeffizientensatz) zugeordnet werden, die dafür sogen sollen, daß die Übertragungsfunktion des Übertragungsgliedes sich in kleinen Schritten von einer Anfangs- bis zu einer Endübertragungsfunktion verändert.

Auch diese Übertragungsanordnung hat noch einige Nachteile:

1. Um eine deutliche Verbesserung gegenüber einem abrupten Umschalten zu erzielen, sind in manchen Fällen relativ viele Zwischenschritte notwendig.

2. Während dieser Zwischenschritte werden die Übertragungskoeffizienten unabhängig voneinander zwischen ihren jeweiligen Anfangs- und Endwert linear interpoliert. Dabei können die diesen Zwischenkoeffizienten zugeordneten Übertragungsfunktionen unter Umständen erheblich mehr von den Anfangs- oder Endübertragungsfunktionen abweichen als diese beiden voneinander. Dadurch kann es während des Umschaltvorganges zu erheblichen Störsignalen kommen.

3. Für die Gewinnung der Zwischenkoeffizienten sind spezielle Interpolationsmittel notwendig.

In einer weiteren Patentanmeldung (P 37 02 215, BK 86/141), ist vorgeschlagen worden, zwischen dem Anfangs- und dem Endkoeffizientensatz nur einen einzigen Zwischenkoeffizientensatz einzufügen, der in Abhängigkeit vom Anfangs- und Endkoeffizientensatz derart bestimmt wird, daß die beim Umschalten zu erwartende Störleistung minimiert wird. Die Berechnung dieses Zwischenkoeffizientensatzes ist jedoch kompliziert und aufwendig sein, außerdem kann unter Umständen ein einziger Zwischensatz doch zu hörbarem Umschaltknacken führen.

Der vorliegenden Erfindung lag die Aufgabe zugrunde, ein Verfahren bzw. eine Übertragungsanordnung der eingangs genannten Art anzugeben, die bei möglichst geringem Rechen- und Schaltungsaufwand eine möglichst störungsarme Umschaltung ermöglichen.

Die Lösung dieser Aufgabe erfolgt durch die kennzeichnenden Merkmale des Anspruches 1, 3 bzw. 4 und 6. Vorteilhafte Ausgestaltungen ergeben sich durch die Unteransprüche.

Das erfindungsgemäße Verfahren bzw. die erfindungsgemäße Anordnung haben den Vorteil einer störungsarmen Umschaltung, wobei der Aufwand relativ gering ist.

Die Erfindung geht aus von der Idee, die interpolative Koeffizientenumschaltung dahin gehend weiterzuentwickeln, daß nicht die Interpolation zwischen Anfangs- und Endkoeffizientensatz linear vorgenommen wird, sondern daß entweder die Distanz zwischen den Polen bzw. Nullstellen der Anfangsstellung und der Endstellung linear in n-Schritten interpoliert wird oder daß der Vektor zwischen Anfangsstellung und Endstellung eines dritten Parameters, beispielsweise Mittenfrequenz, Verstärkung, Bandbreite, Bezugsfrequenz, Durchlaßgrenzfrequenz von Tief- bzw. Hochpässen, Extremalverstärkung oder Dämpfung von Entzerrerfiltern bei konstanter Mittenfrequenz und Bandbreite usw., linear interpoliert wird.

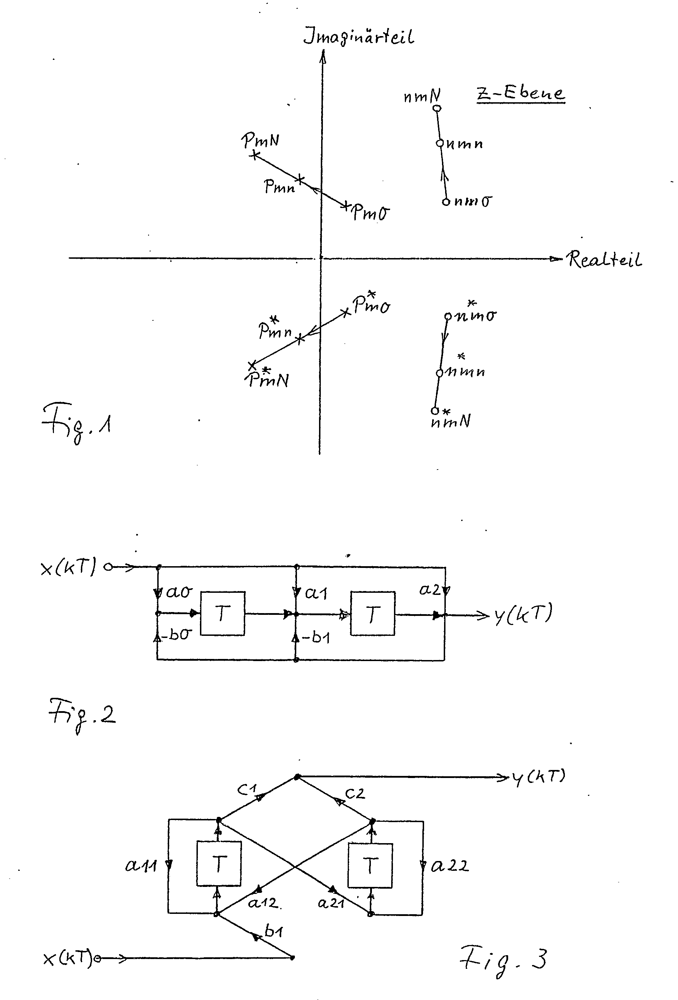

Es folgt die Beschreibung der Erfindung anhand der Figuren. Die Figur 1 zeigt die z-Ebene, das ist die Ebene für die komplexe Frequenz $z := e^{j2\pi f/fA}$, fA = Abtastfrequenz, mit einer Anfangs-Nullstelle nm0 und der dazu konjugiert komplexen Größe nm0* sowie einem Anfangspol Pm0 und dem dazu konjugiert komplexen Pol Pm0*. Die End-Nullstellen sind mit nmN bzw. nmN* und die Endpole mit PmN und PmN* gegeben. Die Anfangsgrößen, also vor dem Umschaltezeitpunkt, und die Endgrößen, also nach vollzogener Umschaltung, sind jeweils durch eine Gerade miteinander verbunden, wobei diese Distanz jeweils in N äquidistante Teile unterteilt sei. Die Umschaltung erfolgt also jeweils durch inkrementales Weiterschalten um ein solches Inkrement. Stellvertretend für die dazwischenliegenden Nullstellen sind nmn und nmn* und für die dazwischenliegenden Pole Pmn und Pmn* eingezeichnet. Zur Realisierung der beschriebenen Vorgehensweise nach Patentanspruch 1 ist der Realteil und der Imaginärteil der Pole und Nullstellen jeweils linear zu interpolieren; statt p und n wird im folgenden der allgemeine Parameter q verwendet:

$$qn = q0 + n \cdot (qN - q0)/N = q0 + n \cdot \Delta q/N$$

oder entsprechend für Real- und Imaginärteil

$$Re(qn) = Re(q0) + n \cdot Re(\Delta q)/N$$
$$Im(qn) = Im(q0) + n \cdot Im(\Delta q)/N$$

für $n = 1, 2, ... N$.

In Figur 2 ist das Blockschaltbild eines digitalen Fiters der direkten Form zweiter Ordnung gezeichnet. Dieser Block kann auch als Teilsystem eines Filters höherer Ordnung eingesetzt werden. Die Eingangsgröße x(kT) wird mittels eines Koeffzienten a0 bewertet und einem ersten jeweils um den Schritttakt T verzögernden Verzögerungsglied T eingegeben und mit einem zweiten Koeffizienten a1 bewertet in ein zweites Verzögerungsglied T gegeben, sowie mit einem weiteren Koeffizienten a2 bewertet, als Teil des Ausgangssignals y(kT), dessen anderer Teil das Ausgangssignal des zweiten Verzögerungsgliedes ist. Dieses Ausgangssignal wird, mit -b1 bewertet, auf das zweite Verzögerungsglied zurückgekoppelt und, mit -b0 bewertet, auf das erste Verzögerungsglied zurückgekoppelt.

Die Übertragungsfunktion dieses Filters ist H(z) = Y(z)/X(z) mit X(z) als z-Transformierte von x(kT).
Ausgedrückt mit Koeffizienten ist die Übertragungsfunktion

$$H(z) = \frac{a2z^2 + a1z + a0}{z^2 + b1z + b0}$$

oder mit den Polen p, p* und den Nullstellen n, n*

$$H(z) = a2\frac{(z-n)(z-n^*)}{(z-p)(z-p^*)} = a2\frac{z^2 - 2\,Re(n) + |n|^2}{z^2 - 2\,Re(p) + |p|^2}$$

Durch Koeffizientenvergleich erhält man für die Koeffizienten für einen beliebigen Zwischenzustand Index n:

$$a1_n = -2a2 \ Re(n_n)$$

$$a0_n = a2|n_n|^2 = a2\left[Re^2(n_n) + Jm^2(n_n)\right]$$

$$b1_n = -2Re(p_n)$$

$$b0_n = |p_n|^2 = Re^2(p_n) + Jm^2(p_n)$$

$$a2 = \text{const.}$$

Ergebnis: $a1n$ und $b1n$ ändern sich bei linearer Interpolation der Pole und Nullstellen ebenfalls linear, nicht dagegen $a0n$ und $b0n$.

Als zweites Beispiel zeigt die Figur 3 das Blockschaltbild eines digitalen Filters in Zustandsraumstruktur der Normalform als Teilsystem zweiter Ordnung, hier der Parallelform, weshalb die direkte Verbindung des Eingangs $x(kT)$ zum Ausgangssignal $y(kT)$ fehlt. Das Eingangssignal wird mit b1 bewertet und einem ersten Verzögerungsglied zugeführt, dessen Ausgangssignal mit a21 bewertet einem zweiten Verzögerungsglied zugeführt wird und mit c1 bewertet den einen Teil des Ausgangssignals ergibt. Beide Verzögerungsglieder sind direkt rückgekoppelt mittels einer Bewertung a11 bzw. a22; weiterhin ist eine kreuzweise Rückkopplung vom zweiten Verzögerungsglied auf den Eingang des ersten mit der Bewertung a12 und vom Ausgang des ersten zum Eingang des zweiten mit der Bewertung a21.
Es gelten beispielsweise die Gleichungen
a11 = a22 = Realteil (p) und
a12 = -a21 = Imaginärteil (p).
Ausgedrückt durch Koeffizienten nimmt die Übertragungsfunktion die Form an

$$H(z) : b1 \ \frac{c1 \ . \ z + (c2 \ . \ a21 - c1 \ . \ a22)}{z^2 - (a11 + a22) \ z + a11 \ . \ a22 - a12 \ . \ a21}$$

oder mit den Polen p, p* und Nullstellen n (reell)

$$H(z) = c1 \ . \ b1 \ \frac{z-n}{z^2 \ . \ 2Re(p) + |p|^2} \ .$$

Mit der Annahme
$a11_n = a22_n = Re(p_n)$ und
$a12_n = -a21_n = Jm(p_n)$
erhält man für einen beliebigen Zwischenzustand Index n mit Hilfe eines Koeffizientenvergleichs obiger Übertragungsfunktionen

$$c2_n = \frac{c1_n}{Jm(p_n)} \ \left[n_n - Re(p_n)\right]$$

für $Jm(p_n) \neq 0$ für alle n
oder

$$c1_n = \frac{c2_n \ Jm(p_n)}{n_n - Re(p_n)}$$

für $n_n - Re(p_n) \neq 0$ für alle n.
Als Ergebnis bei diesem Beispiel ist festzustellen, daß alle Koeffizienten sich bei linearer Interpolation der Pole und der Nullstellen ebenfalls linear ändern mit Ausnahme der Koeffizienten c1n bzw. c2n. Darüber hinaus kann die Änderung von b1n und c2n bzw. c1n beliebig vorgegeben werden, hiervon ist dann die Art der nichtlinearen Änderung von c1n bzw. c2n abhängig.

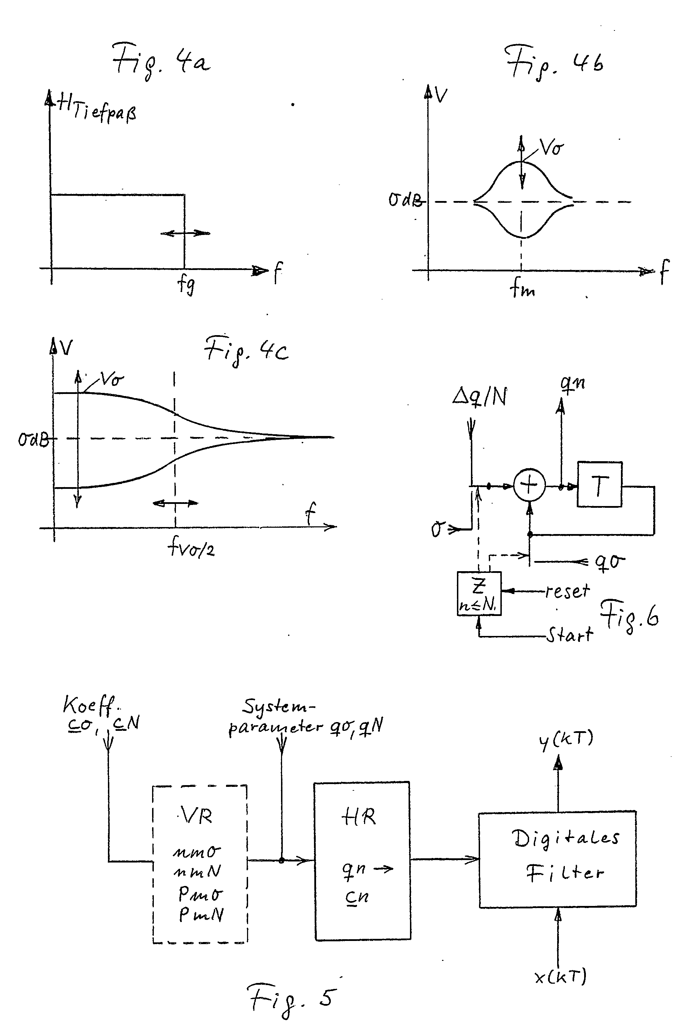

Die Figuren 4a, 4b und 4c dienen zur Illustration der Beispiele für Systemparameter. In Figur 4a ist die Übertragungscharakteristik eines Tiefpasses aufgetragen über der Frequenz f mit der Grenzfrequenz fg als Systemparameter, der veränderbar ist.

In Figur 4b ist die Verstärkungscharakteristik v über der Frequenz f aufgetragen für Entzerrerfilter, hier beispielsweise mit der konstanten Mittenfrequenz fm und einer konstanten Bandbreite, wobei die Extremalverstärkung v0 oder auch die Dämpfung variiert werden kann. Selbstverständlich können auch die Systemparameter Mittenfrequenz fm linear variiert werden bei konstanter Verstärkung v0 und konstanter Bandbreite, oder aber es kann auch die Bandbreite verändert werden bei konstanter Extremalverstärkung v0 und konstanter Mittenfrequenz fm. Schließlich zeigt die Figur 4c die Übertragungscharakteristik eines Tiefen(Höhen-)Shelving-Filters, wobei beispielsweise die Systemparameter Extremalverstärkung v0 bei festgehaltener Bezugsfrequenz $f_{v0/2}$, bei der die Verstärkung im logarithmischen Maß den halben Wert annimmt, oder die Bezugsfrequenz $f_{v0/2}$ bei festgehaltener Extremalverstärkung v0 linear variiert werden können.

In Figur 5 ist ein Blockschaltbild wiedergegeben für eine Anordnung zur Realisierung des erfindungsgemäßen Verfahrens. Rechts ist das digitale Filter erkennbar, mit der Eingangsgröße x(kT) und der Ausgangsgröße y(kT), welches schaltbar ist. Zur Umschaltung wird ein Hilfsrechner HR herangezogen, welcher aus den ihm eingegebenen Systemparametern q0 und qN, das sind die Anfangs- und Endwerte, mittels einer linearen Interpolation die zugehörigen Zwischenwerte qn bzw. die Inkremente qn errechnet und daraus die zugehörigen Zwischenkoeffizientensätze cn ermittelt, welche dem digitalen Filter eingegeben werden. Falls als Eingabeparameter die Anfangs- und Endkoeffizientensätze c0 bzw. cN vorliegen, wird mittels eines weiteren Rechners VR die Ermittlung der entsprechenden Anfangs- und Endnullstellen nm0 und nmN bzw. die Anfangspole und die Endpole Pm0 und PmN durchgeführt. Die Ergebnisse dieses Vorrechners VR werden dann dem Hilfsrechner HR als Systemparameter zur weiteren Verarbeitung zugeleitet.

In Figur 6 ist ein Blockschaltbild für eine Anordnung wiedergegeben, welche aus dem Imkrement Δq/N und der Eingangs-Systemparametergröße q0 jeweils die Zwischen-Systemparametergrößen qn ermittelt. Hierzu ist ein Verzögerungsglied T vorgesehen, dem zu Anfang über einen Schalter die Eingangsgröße q0 eingegeben wird. Das Verzögerungsglied ist über ein Summierglied plus rückgekoppelt, welchem über seinen zweiten Eingang und einen zweiten Schalter das Inkrement Δq/N zugeführt wird. Die beiden Schalter werden durch einen Zähler Z angesteuert, wobei der erste Schalter beim Start kurzzeitig den Anfangs-Systemparameterwert q0 zuführt und der zweite Schalter die Eingabe des Inkrements Δq/N so lange veranlaßt, bis der Zähler Z den Wert N erreicht hat.

## Ansprüche

1. Verfahren zur digitalen Übertragung, das mit codierten abtastproben arbeitet und wobei die Übertragungsfunktion ohne Betriebsunterbrechung ausgehend von einer Anfangsübertragungsfunktion störungsarm bis zu einer Endübertragungsfunktion verändert werden kann, wobei mittels Umschaltmitteln für die jeweils einem Übertragungsglied zuzuordnenden Übertragungskoeffizienten eine Umschaltung von einem Anfangskoeffizientensatz auf einen Endkoeffizientensatz bewirkt wird, dadurch gekennzeichnet,

daß die Umschaltung vom Anfangskoeffizientensatz c0 auf den Endkoeffizientensatz cN in mehreren Schritten so erfolgt,

daß die Lage der Pole Pm0 und Nullstellen nm0 in der z-Ebene der komplexen Frequenz für den Anfangskoeffizientensatz c0 und für den Endkoeffizientensatz cN festgestellt wird,

daß jeweils die Distanz zwischen den Polen Pm0 für den Anfangskoeffizientensatz und den zugehörigen Polen PmN für den Endkoeffizientensatz sowie die Distanz zwischen den Nullstellen Nm0 für den Anfangskoeffizientensatz und den zugehörigen Nullstellen nmN für den Endkoeffizientensatz in N Teile geteilt wird,

daß jeweils für die zwischen den Anfangspolen Pm0 und den Endpolen PmN liegenden Pole Pmn und für die zwischen den Anfangsnullstellen nm0 und den Endnullstellen nmN liegenden Nullstellen nmn die Zwischenkoeffizientensätze cn ermittelt werden und

daß ausgehend von dem Anfangskoeffizientensatz schrittweise jeweils auf die den nächstfolgenden Inkrementen entsprechenden Zwischenkoeffizientensätze cn umgeschaltet wird, bis der Endkoeffizientensatz cN erreicht ist.

2. Verfahren nach Anspruch 1, dadurch gekennzeichnet, daß die Umschaltung vom Anfangskoeffizientensatz $c0$ auf den Endkoeffizientensatz $cN$ in N Zwischenschritten mit äquidistantem Inkrement linear interpoliert wird, indem der Realteil und der Imaginärteil des komplexen Zeigers zwischen Anfangspol und Endpol bzw. Anfangsnullstelle und Endpol linear interpoliert wird zu

$qn = q0 + n(qN - q0)/N = q0 + N\Delta q/N$

oder $Re(q0) + n/N . Re(\Delta q)$ und

$Im(q0) + n/N. Im(\Delta q)$

mit $n = 1, 2, .... N.$

3. Verfahren nach Anspruch 1, dadurch gekennzeichnet,

daß die Umschaltung vom Anfangskoeffizientensatz $c0$ auf den Endkoeffizientensatz $cN$ in N Zwischenschritten nichtlinear, beispielsweise mit logarithmischen Inkrementen, interpoliert wird.

4. Verfahren zur digitalen Übertragung, das mit codierten Abtastproben arbeitet und wobei die Übertragungsfunktion ohne Betriebsunterbrechung ausgehend von einer Anfangsübertragungsfunktion störungsarm bis zu einer Endübertragungsfunktion verändert werden kann, wobei mittels Umschaltmitteln für die jeweils einem Übertragungsglied zuzuordnenden Übertragungskoeffizienten eine Umschaltung von einem Anfangskoeffizientensatz auf einen Endkoeffizientensatz bewirkt wird, dadurch gekennzeichnet,

daß die Umschaltung vom Anfangskoeffizientensatz $c0$ auf den Endkoeffizientensatz $cN$ in mehreren Schritten so erfolgt, daß ein vorgegebener Systemparameter, ausgehend von einem Anfangswert $q0$ über Zwischenwerte $qn$ zu einem gewünschten Endwert $qN$, in äquidistanten Inkrementen linear interpoliert wird mit

$qn = q0 + n . (qN - q0)/N = q0 + n . \Delta q/N,$

daß jeweils für diese Zwischenwerte $qn$ die entsprechenden Zwischenkoeffizientensätze $cn$ ermittelt wird und

daß ausgehend von dem Anfangskoeffizientensatz $c0$ schrittweise jeweils auf die den nächstfolgenden Inkrementen entsprechenden Zwischenkoeffizientensätze $cn$ umgeschaltet wird, bis der Endkoeffizientensatz $cN$ erreicht ist.

5. Digitale Übertragungsanordnung, die mit codierten Abtastproben arbeitet und deren Übertragungsfunktion ohne Betriebsunterbrechung ausgehend von einer Anfangsübertragungsfunktion störungsarm bis zu einer Endübertragungsfunktion verändert werden kann, wobei mittels Umschaltmitteln für die jeweils einem Übertragungsglied der Anordnung zuzuordnenden Übertragungskoeffizienten eine Umschaltung von einem Anfangskoeffizientensatz auf einen Endkoeffizientensatz bewirkt wird, dadurch gekennzeichnet,

daß Mittel vorgesehen sind, mit denen die Lage der Pole $Pm0$ und Nullstellen $nm0$ in der z-Ebene der komplexen Frequenz für den Anfangskoeffizientensatz $c0$ und für den Endkoeffizientensatz $cN$ festgestellt wird, mit denen jeweils die Distanz zwischen den Polen $Pm0$ für den Anfangskoeffizientensatz von den zugehörigen Polen $PmN$ für den Endkoeffizientensatz sowie die Distanz zwischen den Nullstellen $Nm0$ für den Anfangskoeffizientensatz und den zugehörigen Nullstellen $nmN$ für den Endkoeffizientensatz in N Teile geteilt wird und mit denen jeweils für die zwischen den Anfangspolen $Pm0$ und den Endpolen $PmN$ liegenden Pole $Pmn$ und für die zwischen den Anfangsnullstellen $nm0$ und den Endnullstellen $nmN$ liegenden Nullstellen $nmn$ die Zwischenkoeffizientensätze $cn$ ermittelt werden und

daß die Umschaltmittel so ausgebildet sind, daß ausgehend von dem Anfangskoeffizientensatz schrittweise jeweils auf die den nächstfolgenden Inkrementen entsprechenden zwischenkoeffizientensätze $cn$ umgeschaltet wird, bis der Endkoeffizientensatz $cN$ erreicht ist.

6. Anordnung nach Anspruch 5, dadurch gekennzeichnet,

daß durch die Mittel die Umschaltung vom Anfangskoeffizientensatz $c0$ auf den Endkoeffizientensatz $cN$ in N Zwischenschritten mit äquidistantem Inkrement linear interpoliert wird, indem der Realteil und der Imaginärteil des komplexen Zeigers zwischen Anfangspol und Endpol bzw. Anfangsnullstelle und Endpol linear interpoliert wird zu

$qn = q0 + n(qN - q0)/N = q0 + N\Delta q/N$

oder $Re(q0) + n/N . Re(\Delta q)$ und

$Im(q0) + n/N . Im(\Delta q)$

mit $n = 1, 2, .... N.$

7. Digitale Übertragungsanordnung nach Anspruch 5,

dadurch gekennzeichnet, daß die Umschaltung vom Anfangskoeffizientensatz $c0$ auf den Endkoeffizientensatz $cN$ in N Zwischenschritten nichtlinear, beispielsweise mit logarithmischen Inkrementen, interpoliert wird.

8. Digitale Übertragungsanordnung, die mit codierten Abtastproben arbeitet und deren Übertragungsfunktion ohne Betriebsunterbrechung ausgehend von einer Anfangsübertragungsfunktion störungsarm bis zu einer Endübertragungsfunktion verändert werden kann, wobei mittels Umschaltmitteln für die jeweils einem Übertragungsglied der Anordnung zuzuordnenden Übertragungskoeffizienten eine Umschaltung von einem Anfangskoeffizientensatz auf einen Endkoeffizientensatz bewirkt wird, dadurch gekennzeichnet,

daß Mittel vorgesehen sind, durch die ein vorgegebener Systemparameter, ausgehend von einem Anfangswert $q_0$ über Zwischenwerte $q_n$ zu einem gewünschten Endwert $q_N$, in äquidistanten Inkrementen linear interpoliert wird mit

$q_n = q_0 + n \cdot (q_N - q_0)/N = q_0 + n \cdot \Delta q/N$ und durch die jeweils für diese Zwischenwerte $q_n$ die entsprechenden Zwischenkoeffizientensätze $c_n$ ermittelt werden und

daß die Umschaltmittel so ausgebildet sind, daß ausgehend von dem Anfangskoeffizientensatz $c_0$ schrittweise jeweils auf die den nächstfolgenden Inkrementen entsprechenden Zwischenkoeffizientensätze $c_n$ umgeschaltet wird, bis der Endkoeffizientensatz $c_N$ erreicht ist.

9. Anordnung nach Anspruch 5, 6, 7 oder 8, dadurch gekennzeichnet,

daß die Mittel einem Rechner (VR, HR) beinhalten (Figur 5).

Fig. 1

Fig. 2

Fig. 3

BK 87/30

Fig. 4a

Fig. 4b

Fig. 4c

Fig. 6

Fig. 5

BK 87/30

# EUROPÄISCHER RECHERCHENBERICHT

Europäisches
Patentamt

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | FR-A-2 164 653 (SIEMENS AG) <br> * Seite 1, Zeilen 28-35; Seite 5, Zeile 33 - Seite 6, Zeile 12; Seite 7, Zeile 8 - Seite 8, Zeile 12; Figur 1 * <br> --- | 4,8,9 | H 03 H 17/02 |
| D,A | EP-A-0 135 066 (ANT NACHRICHTENTECHNIK GmbH) <br> * Seite 1, Zeile 1 - Seite 2, Zeile 10; Seite 4, Zeilen 13-33; Seite 7, Zeilen 15-32; Figuren 1,2 * <br> --- | 1,2,4-6 ,8,9 | |
| A | DE-A-3 621 632 (BOGNER) <br> * Spalte 3, Zeile 65 - Spalte 4, Zeile 15; Spalte 7, Zeilen 13-40; Spalte 9, Zeilen 19-31 * <br> --- | 1,4,5,8 | |
| A | R.W. LUCKY et al.: "Principles of data communication", 1968, Seiten 150-156, McGraw-Hill, New York, US <br> * Seite 154, Zeilen 14-26 * <br> ----- | 3,7 | RECHERCHIERTE SACHGEBIETE (Int. Cl.4) <br><br> H 03 G <br> H 03 H <br> H 04 L |

Der vorliegende Recherchenbericht wurde für alle Patentansprüche erstellt

| Recherchenort | Abschlußdatum der Recherche | Prüfer |
|---|---|---|
| DEN HAAG | 11-05-1989 | DEN OTTER A.M. |